# EUROPÄISCHE PATENTSCHRIFT

(11) **EP 3 202 040 B1**
(45) Veröffentlichungstag und Bekanntmachung des Hinweises auf die Patenterteilung: **07.04.2021**
(21) Anmeldenummer: 15781865.9
(22) Anmeldetag: 24.09.2015
(51) Int. Cl.: H03K 17/955, B25J 13/08

(54) **NÄHERUNGSSENSORANORDNUNG**
PROXIMITY SENSOR ARRAY
ENSEMBLE CAPTEUR DE PROXIMITÉ

(30) Priorität: 29.09.2014 DE 102014014050
(43) Veröffentlichungstag der Anmeldung: 09.08.2017
(73) Patentinhaber: ABB Schweiz AG, 5400 Baden (CH)
(72) Erfinder: GOMBERT, Bernd, 82237 Wörthsee (DE); HÖSL, Werner, 92507 Nabburg (DE); WOLFF, Alexander, 01471 Radeburg (DE); ANDRYSEK, Richard, 86911 Dießen a.A. (DE); KRAUSEN, Leopold, 81375 München (DE)
(74) Vertreter: Beetz & Partner mbB
(86) Internationale Anmeldenummer: PCT/EP2015/001903
(87) Internationale Veröffentlichungsnummer: WO 2016/050344

(56) Entgegenhaltungen:
- WO-A1-2006/025000
- WO-A1-2011/124752
- WO-A1-2013/093326
- DE-A1-102005 003 492
- DE-U1- 20 004 404
- JP-A- S63 238 502
- JP-A- 2001 057 126
- JP-A- 2010 010 116
- US-A- 5 539 292
- US-A1- 2013 241 280

## Beschreibung

Die Erfindung betrifft eine Näherungssensoranordnung zum Detektieren von sich der Anordnung nähernden Objekten mit einer Unterlage und einem Träger, der einen Näherungssensor mit einer Messelektrode und einer sich zwischen der Messelektrode und einer Oberfläche der Unterlage erstreckenden Schildelektrode trägt. Eine solche Näherungssensoranordnung ist aus WO 2013/093 326 A1 und JP 2010 010116 A bekannt. Befestigungsmittel zum Befestigen des Trägers an der Unterlage sind in diesem Dokument erwähnt, aber nicht beschrieben.

Der Erfindung liegt die Aufgabe zugrunde, eine Näherungssensoranordnung zu schaffen, die platzsparend und robust ist.

Die Aufgabe der Erfindung wird gelöst durch eine Näherungssensoranordnung mit einer Unterlage wie etwa einem Roboterarm, einer auf einer Oberfläche der Unterlage montierten, Kontaktflächen tragenden Platine und wenigstens einem Träger, der zu den Kontaktflächen der Platine komplementäre Kontaktflächen und wenigstens einen mit den Kontaktflächen verbundenen Näherungssensor mit einer Messelektrode und einer sich zwischen Messelektrode und Oberfläche erstreckenden Schildelektrode trägt, wobei zum Inkontaktbringen der Kontaktflächen der Platine und des Trägers Unterlage und Träger in einer zu der Oberfläche parallelen Steckrichtung steckverbunden sind.

Diese Steckverbindung kann auf unterschiedliche Weise hergestellt werden. Einem ersten Ansatz zufolge ist der Träger selber auf die Unterlage aufsteckbar, so dass er sie im steckverbundenen Zustand reib- und/oder formschlüssig umgreift.

Einem zweiten Ansatz zufolge kann die Steckverbindung zwischen Unterlage und Träger indirekt, über die Platine, zustande kommen, indem die Kontaktflächen Teile von zueinander komplementären elektrischen Steckverbindern des Trägers und der Platine sind.

In beiden Fällen kann aufgrund der oberflächenparallelen Steckrichtung ein langer Steckweg in einem eng begrenzten Bauraum über der Oberfläche der Unterlage untergebracht werden. Insbesondere kann die Höhe dieses Bauraums kleiner sein als die Länge des Steckweges.

Da durch die mechanische Steckverbindung der Näherungssensor zugleich auch elektrisch kontaktiert wird, minimiert sich der Montageaufwand.

Auch kann ein defekter Näherungssensor ganz ohne Verkabelungsaufwand durch Aufstecken eines anderen Trägers mit einem intakten Näherungssensor einfach ausgewechselt werden.

Die Kontaktflächen der Platine und des Trägers sind vorteilhafterweise in Steckrichtung ausgerichtet oder ausgedehnt. So kann ein elektrischer Kontakt trotz Toleranzen bei der Positionierung des Trägers sichergestellt werden.

Beispielsweise kann eine der Kontaktflächen als eine elektrisch leitende Feder ausgebildet sein, die sich beim Stecken des Trägers auf eine komplementäre Kontaktfläche aufschiebt und, indem sie sich dabei elastisch verformt, zum Reibschluss der Steckverbindung beiträgt.

Der Träger weist vorteilhafterweise eine starre Grundplatte auf und die Messelektrode und die Schildelektrode sind an entgegengesetzten Oberflächen der Grundplatte angeordnet.

Die starre Grundplatte bietet eine Grundlage einer ganzheitlichen Befestigung der Elektroden und verleiht der Näherungssensoranordnung Stabilität, insbesondere gegenüber durch Vibrationen und Schwingungen hervorgerufene Ablöseerscheinungen der Näherungssensoren. Die Elektroden können auf den Träger aufgedampft, aufgedruckt oder aufgalvanisiert sein.

Die Grundplatte kann darüber hinaus als Isolator genutzt werden, der die Messelektrode von der Schildelektrode trennt.

Einer der komplementären Steckverbinder kann einen Rand der Grundplatte oder der Platine umfassen, wobei die Kontaktflächen auf dem Rand angeordnete Kontaktfelder sein können. Diese Kontaktfelder sind kostengünstig bei der Fertigung der Grundplatte oder Platine mit bekannten Massenproduktionstechniken realisierbar, die Montage eines Steckverbinderbauteils auf der Grundplatte oder der Platine erübrigt sich. Der andere Steckverbinder muss, um den Rand aufnehmen zu können, mit diesem in zur Oberfläche der Unterlage senkrechter Richtung überlappen, woraus sich eine weitere Minimierung des Überstands über die Unterlage ergibt. Wenn die Kontaktflächen am Rand der Grundplatte angebracht sind, können die Mess- und Schildelektroden großflächig und frei von Unterbrechungen durch etwaige Bauteile auf der Grundplatte aufgebracht werden.

Vorzugsweise ist jeweils eines der Kontaktfelder einteilig mit der Messelektrode und ein anderes einteilig mit der Schildelektrode ausgebildet. So können die Elektroden und Kontaktfelder rationell in einem einzigen Arbeitsgang ausgebildet werden.

Die Grundplatte kann über die die Schildelektrode tragende Oberfläche überstehende Vorsprünge aufweisen. Die Vorsprünge halten die Schildelektrode auf Abstand zur Unterlage und verhindern, dass sich die Schildelektrode und die eventuell leitfähige Unterlage kurzschließen können.

Wenigstens einer der Vorsprünge kann eine entlang einer Kante der Schildelektrode verlaufende Rippe sein. So kann der Vorsprung als Isolator gegenüber einer weiteren Schildelektrode dienen, die zur ersteren Schildelektrode benachbart und mit dieser auf einer gemeinsamen Oberfläche angeordnet ist.

Der Träger kann an der Unterlage durch wenigstens eine Schraube gesichert sein.

Eine Bohrung der Grundplatte, die eine solche Schraube aufnehmen kann, verläuft vorzugsweise durch einen der Vorsprünge. So ist sichergestellt, dass beim Festziehen der Schraube die Schildelektrode nicht gegen die Unterlage gedrückt werden kann.

Die Schraube ist vorzugsweise quer zur Steckrichtung orientiert. So kann sie beim Festziehen keine Bewegung der Kontaktflächen gegeneinander bewirken.

Der Träger ist vorzugsweise als sich in einer Längsrichtung erstreckende Rinne geformt. Somit kann der Träger die Unterlage zumindest teilweise umgreifen.

Wird die Schildelektrode an einer der Unterlage zugewandten Innenseite der Rinne und die Messelektrode an einer von der Unterlage abgewandten Außenseite der Rinne angebracht, dann kann die Schildelektrode die Messelektrode vor Störungen der Unterlage abschirmen.

Vorzugsweise weist die Näherungssensoranordnung zumindest zwei Träger auf, die sich zu einer die Unterlage rohrförmig umschließenden Hülle ergänzen. So ist es auf einfache Weise möglich, Näherungssensoren um den gesamten Umfang der Unterlage zu verteilen, um die Annäherung von Fremdkörpern aus allen Richtungen zu erfassen.

Die Messelektroden und die Schildelektroden der Näherungssensoren erstrecken sich vorzugsweise in einer Querrichtung von einem Rand des Trägers zu einem gegenüberliegenden Rand. So kann insbesondere bei einer rohrförmigen Anordnung von Trägern eine über den gesamten Umfang dieser Anordnung gleichmäßige Empfindlichkeit erreicht werden.

Sofern am Träger nur ein einziger Näherungssensor angebracht ist, kann die Stelle, der sich ein Objekt nähert, nicht exakt lokalisiert werden. Daher sollten am Träger in der Längsrichtung mehrere Näherungssensoren verteilt sein. So kann die Stelle, der sich ein Objekt nähert, anhand desjenigen Näherungssensors erkannt werden, der am stärksten auf das Objekt anspricht.

Zum Kontaktieren der mehreren Näherungssensoren können entlang der Platine mehrere Kontaktflächen verteilt sein.

Die Platine weist vorzugsweise zwei Gruppen von Kontaktflächen auf, und zwei Träger sind aus einander entgegengesetzten Steckrichtungen mit der Unterlage steckverbunden.

Vorzugsweise sind die Messelektroden der Näherungssensoren in der Längsrichtung schmaler als die Schildelektroden ausgebildet. Dadurch kann die Messelektrode besser von der Schildelektrode gegen von der Unterlage ausgehende Störungen geschirmt werden.

Der Erfassungsbereich eines jeden Näherungssensors ist limitiert. Daher sieht eine Weiterbildung der Erfindung einen Schalter vor, durch den mehrere Näherungssensoren parallel geschaltet werden können. Zwar wirken dann die parallel geschalteten Näherungssensoren wie ein einzelner Näherungssensor; d. h. es kann nicht mehr unterschieden werden, welchem der parallel geschalteten Näherungssensoren ein sich näherndes Objekt zuerst nähert. Jedoch bewirkt diese Maßnahme, dass sich die Reichweite des Erfassungsbereichs der parallel geschalteten Näherungssensoren (im Vergleich zu nicht parallel geschalteten Näherungssensoren) erweitert, um ein sich näherndes Objekt schon aus weiterem Abstand erfassen zu können.

Die Parallelschaltung kann durch den Schalter teilweise oder ganz wieder aufgehoben werden. Dadurch reduziert sich zwar die Reichweite des Erfassungsbereichs der Näherungssensoren wieder, jedoch können aus der größeren Anzahl der verfügbaren Näherungssensoren diejenigen identifiziert werden, denen sich das Objekt zuerst nähert.

Bei Erfassung eines Objekts kann eine erste Präventivmaßnahme ergriffen werden. Beispielsweise kann die Geschwindigkeit des Roboters reduziert werden.

Weitere Merkmale und Vorteile der Erfindung ergeben sich aus der nachfolgenden Beschreibung von Ausführungsbeispielen unter Bezugnahme auf die beigefügten Figuren. Es zeigen:
- Fig. 1: einen Träger mit Näherungssensoren,
- Fig. 2: eine Schnittansicht einer Näherungssensoranordnung,
- Fig. 3: eine von zwei Trägern umschlossene Unterlage,
- Fig. 4: eine detaillierte Ansicht von Steckverbindungen,
- Fig. 5: einen mit der Unterlage in formschlüssiger Verbindung stehenden Träger und
- Fig. 6: einen mit den Trägern bestückten Roboter;

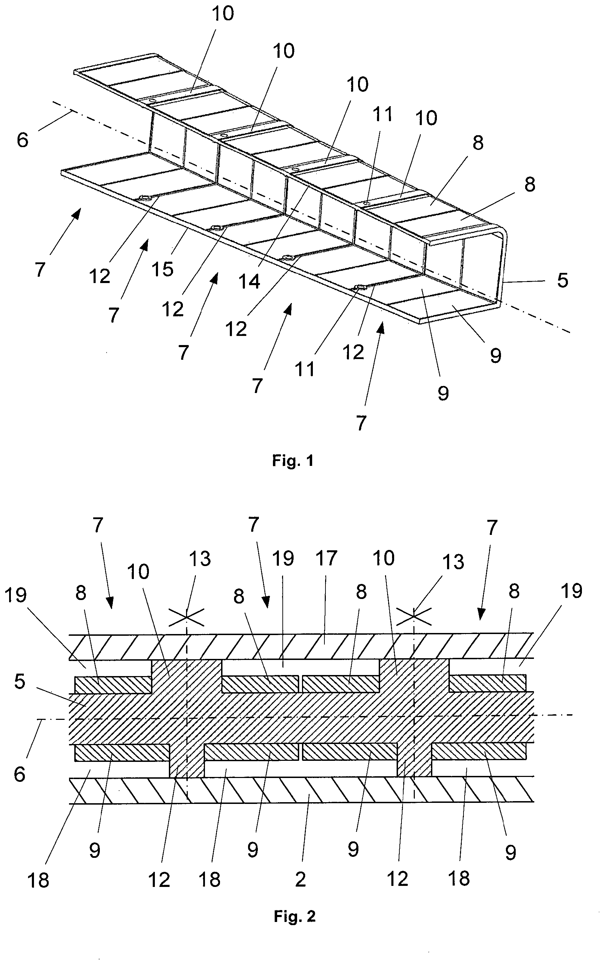

In Fig. 1 ist ein Träger 5 gezeigt. Der Träger 5 ist als eine sich entlang einer Längsrichtung 6 erstreckende Rinne ausgebildet, die im Querschnitt ein U-Profil aufweist. Am Träger 5 sind mehrere Näherungssensoren 7 fest angebracht. Jeder Näherungssensor 7 umfasst eine Messelektrode 8 und eine Schildelektrode 9.

Mess- und Schildelektroden 8 und 9 sind mit dem Träger 5 fest verbunden und können z. B. aufgeklebt sein. In einer bevorzugten Alternative sind die Elektroden auf den Träger 5 aufgalvanisiert oder aufgedampft.

Die Messelektroden 8 sind in Längsrichtung gestaffelt an einer Außenseite des rinnenförmigen Trägers 5 angebracht und erstrecken sich in der Querrichtung über die gesamte Breite der Außenseite, von einem oberen Rand 14 bis zu einem unteren Rand 15. Die Schildelektroden 9 sind an einer Innenseite des rinnenförmigen Trägers 5 angebracht und erstrecken sich ebenfalls über deren gesamte Breite von Rand 14 zum Rand 15. Der Träger 5 ist somit nahezu von den Mess- und Schildelektroden 8 und 9 bedeckt.

Im Vergleich zu den Schildelektroden 9 sind die Messelektroden 8 in Längsrichtung schmaler ausgelegt, so dass jede Schildelektrode 9 in Längsrichtung die ihr gegenüberliegende Messelektrode 8 seitlich überragt. Somit können die Schildelektroden 9 auch die Ränder der Messelektroden 8 gegen Störfelder aus der Unterlage 2 abschirmen.

Der zwischen den Schildelektroden 9.1, 9.2 und Messelektroden 8.1, 8.2 befindliche Träger 5 ist aus einem Isolationsmaterial gebildet, typischerweise aus Kunststoff spritzgeformt, und bewirkt eine elektrische Trennung von Schild- und Messelektroden.

Der Träger 5 weist an der Innenseite ferner mehrere als Rippen ausgebildete Vorsprünge 12 auf, die sich zwischen den Schildelektroden 9 zweier benachbarter Näherungssensoren 7 erstrecken. Indem die Rippen 12 über die Schildelektroden 9 nach innen überstehen, halten sie einen Hohlraum 18 zwischen diesen und der Unterlage 2 offen und stellen so eine galvanische Trennung der Schildelektroden 9 von der Unterlage 2 sicher. Optional kann der Hohlraum 18 mit einem Isoliermaterial ausgefüllt werden.

Die Außenseite des rinnenförmigen Trägers 5 weist hier weitere als Rippen ausgebildete Vorsprünge 10 auf, die über die Messelektroden 8 nach außen überstehen. Die Vorsprünge 10 sind zwischen zwei Näherungssensoren 7 angeordnet und wirken wie ein Isolator, indem sie jeweils eine Messelektrode 8 der beiden benachbarten Näherungssensoren 7 voneinander trennen. Ferner sind die Vorsprünge 10 den Vorsprüngen 12 gegenüberliegend angeordnet.

Die Vorsprünge 10 tragen ein Gehäuse 17, das die Messelektroden 8 vor einer direkten Kontaktierung mit sich an die Näherungssensoren 7 annähernden Objekten schützt. Sie halten zwischen den Messelektroden 8 und dem Gehäuse 17 einen mit Luft gefüllten Hohlraum 19 offen.

Einer nicht gezeichneten Variante zufolge ist der Träger 5 an seiner Außenseite eben, und anstelle des Gehäuses ist als Schutz der Messelektroden 8 eine flexible Folie auf die Außenseite aufgezogen und zwischen zwei benachbarten Messelektroden 8 mit dem Träger 5 verklebt oder verschweißt, oder eine Lackschicht ist auf Messelektroden 8 und Träger 5 aufgetragen.

Durch die Vorsprünge 10 und 12 sind quer zur Längsrichtung 6 des Trägers 5 verlaufende Bohrungen 11 (s. Fig. 1) vorgesehen. Durch die Bohrungen 11 können Schrauben 13 (s. Fig. 2) eingeführt werden, um den Träger 5 ggf. zusammen mit dem Gehäuse 17 an der Unterlage 2 zu befestigen.

Zur Ableitung von Strömen kann die Unterlage 2 geerdet sein.

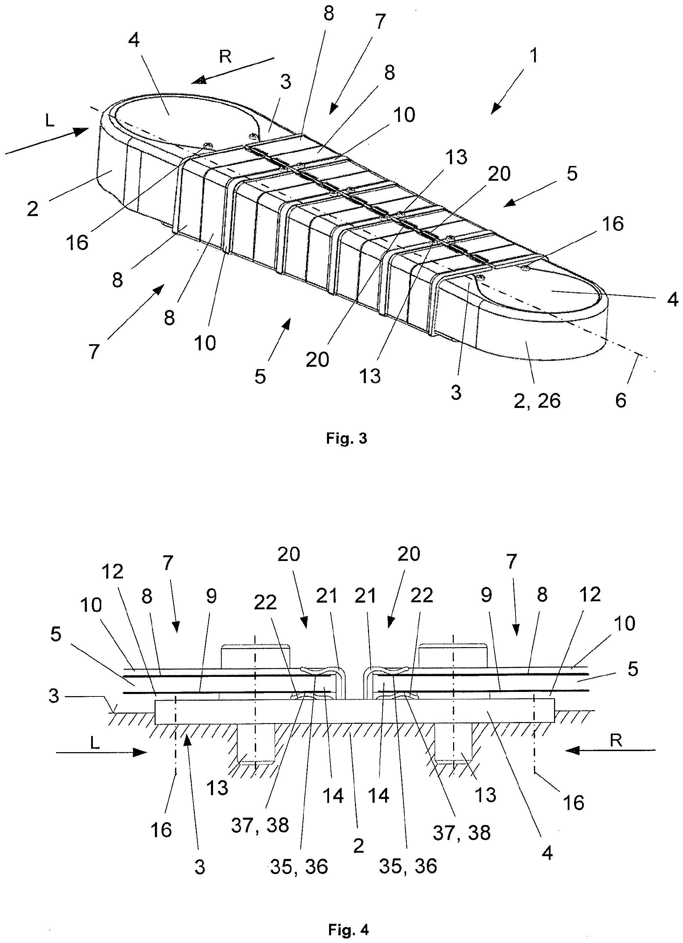

Fig. 3 zeigt eine Näherungssensoranordnung 1, die die Unterlage 2, hier in Form eines Armelements 26 eines Roboterarms, zwei mit Näherungssensoren 7 ausgerüstete Träger 5 sowie eine Platine 4 umfasst. Die Träger 5 umgreifen die Unterlage 2 reibschlüssig, indem der eine Träger 5 aus einer Richtung L und der andere Träger 5 aus einer entgegengesetzten Richtung R aufgeschoben wird, bis ihre innenliegenden Vorsprünge 12 ringsum an der Unterlage 2 anliegen. Die beiden rinnenförmigen Träger 5 ergänzen sich dann zu einer rohrförmigen Struktur und umschließen die sich in Längsrichtung 6 erstreckende Unterlage 2, so dass die Unterlage 2 ringsum von Schildelektroden 9 und Messelektroden 8 der Näherungssensoren 7 umgeben ist.

Die Platine 4 ist an einer Oberfläche 3 der Unterlage 2 fest mit Schrauben 16 angeschraubt. Die Platine 4 kann sämtliche Bauelemente umfassen, die zur Signalverarbeitung der Näherungssensoren 7 benötigt werden. Sie umfasst insbesondere mehrere Federpaare 20 zum Herstellen von elektrischen Verbindungen mit den Elektroden 8, 9 auf den Trägern 5.

Fig. 4 zeigt zwei Federpaare 20 in einem vergrößert dargestellten Ausschnitt. Das linke Federpaar 20 dient zum Einstecken des in Steckrichtung L aufgeschobenen Trägers 5 und das rechte Federpaar 20 dient zum Einstecken des anderen in Steckrichtung R aufgeschobenen Trägers 5.

Jedes Federpaar 20 umfasst jeweils eine obere Feder 21 und eine darunter angeordnete untere Feder 22, die auf der Platine 4 aufgelötet sind und die gemeinsam eine Einstecknut begrenzen. Die Einstecknut des linken Federpaars 20 ist nach links offen und klemmt den oberen Rand 14 des in Steckrichtung L aufgeschobenen linken Trägers 5. Die Einstecknut des rechten Federpaars 20 ist nach rechts offen und klemmt den oberen Rand 14 des in Steckrichtung R aufgeschobenen rechten Trägers 5.

Somit bringen die Federn 21 und 22 auf den zwischen sie gesteckten Träger 5 eine Klemmkraft auf, die den Träger 5 mit der Platine 4 bzw. der mit dieser verbundenen Unterlage 2 reibschlüssig verbindet.

Andererseits dienen die Federn 21 und 22 als Kontaktflächen 35, 37 der Platine 4, die mit korrespondierenden Kontaktflächen 36, 38 der Träger 5 elektrisch leitend verbunden werden können, so dass einer der Ränder 14 jeweils einen männlichen Steckverbinder und die ihn aufnehmenden Federpaare 20 einen dazu komplementären weiblichen Steckverbinder bilden. Die Kontaktflächen 36, 38 sind in einer Reihe entlang der oberen Ränder 14 der Träger 5 angeordnet. Wie Fig. 4 zeigt, wird über die obere Feder 21 ein elektrischer Kontakt mit einer der Messelektroden 8 des Trägers 5 und über die untere Feder 22 ein elektrischer Kontakt mit einer der Schildelektroden 9 des Trägers 5 hergestellt. D. h. die bis zum Rand 14 des Trägers 5 reichenden Mess- und Schildelektroden 8, 9 werden zugleich als Kontaktflächen 36, 38 des Trägers 5 genutzt.

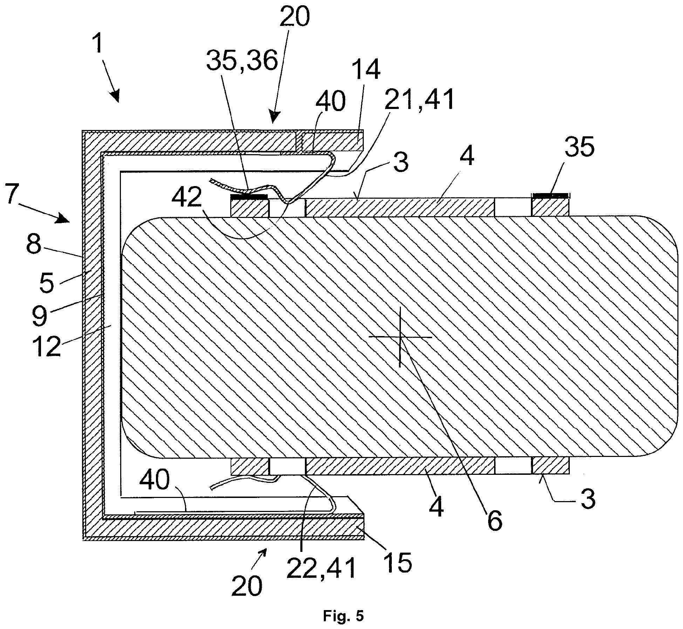

Als Alternative zu der reibschlüssigen Verbindung zeigt Fig. 5 einen mit der Unterlage 2 in formschlüssiger Verbindung stehenden Träger 5. Der Träger 5 ist in Steckrichtung L auf die Unterlage 2 aufgesteckt. An der Innenseite des Trägers 5 sind an dessen oberen Rand 14 eine Feder 21 und an dessen unteren Rand 15 eine weitere Feder 22 befestigt. Den Federn 21 und 22 liegen zwei Platinen 4 gegenüber, die an Ober- und Unterseite der Unterlage 2 befestigt sind.

Die Platinen 4 sind deckungsgleich und entlang ihrer zur Schnittebene der Fig. 5 senkrechten Ränder mit Aussparungen oder Durchbrüchen 39 versehen. Wenigstens eine der Platinen 4, hier die obere Platine 4, weist zwischen jedem Durchbruch 39 und dem dazu benachbarten Rand eine Kontaktfläche 35 auf.

Die Federn 21 und 22 sind haarnadelartig geformt, mit jeweils einem an der Innenseite des Trägers flach anliegenden Schenkel 40 und einem in mehreren Wellen gebogenen Schenkel 41, die über einen dem Rand 14 zugewandte Biegung einteilig zusammenhängen. Eine Welle 42 des gebogenen Schenkels rastet, wenn der Träger 5 in der Steckrichtung L bis zum Anschlag auf die Unterlage 2 aufgeschoben ist, in einen der Durchbrüche 39 der beiden Platinen 4 ein und stellt dadurch einen Formschluss her. Eine zweite Welle bildet eine Kontaktfläche 36, die beim Einrasten in einen der Durchbrüche 39 auch einen elektrischen Kontakt zur dem Durchbruch 39 benachbarten Kontaktfläche 35 der oberen Platine herstellt.

Die Schildelektrode 9 ist in der Umgebung der in Fig. 5 im Schnitt gezeigten Feder 21 ausgespart, so dass zwischen ihr und dieser Feder 21 kein elektrischer Kontakt besteht. Stattdessen ist die Feder 21 über eine Durchkontaktierung 43, d.h. eine lotgefüllte Bohrung des Trägers 5, mit der außen am Träger 5 angeordneten Messelektrode 8 leitend verbunden. Eine weitere Feder, die in der Perspektive der Fig. 5 hinter der gezeigten Feder 21 verborgen ist, ist direkt auf die Schildelektrode 9 aufgelötet. Da somit beide Elektroden jedes Näherungssensors 7 mit der oberen Platine 4 kontaktiert sind, kann auf eine Verdrahtung der unteren Platine 4 verzichtet werden; die Feder 22 dient lediglich der Befestigung des Trägers 5.

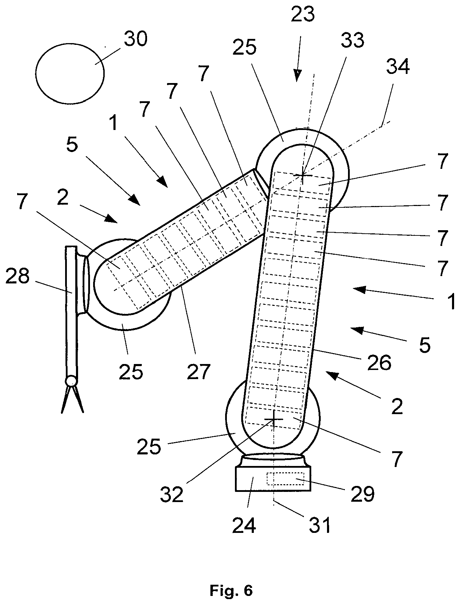

Der erfindungsgemäße Träger 5 ist geeignet, bestehende Systeme nachträglich mit Näherungssensoren auszurüsten. Wie in Fig. 6 gezeigt, können die Träger 5 an Armelemente 26 oder 27 eines Roboters 23 aufgesteckt und/oder angeschraubt werden. Die Armelemente 26 und 27 dienen jeweils als eine sich in eine Längsrichtung erstreckende Unterlage 2, wie z. B. in Fig. 3 gezeigt. Die Platine 4 wird auf eine Oberfläche des als Unterlage 2 dienenden Armelements 26 bzw. 27 angeschraubt. Anschließend können die Träger 5 auf das Armelement 26 bzw. 27 aufgeschoben und in die Federpaare 20 der Platine 4 gesteckt werden.

Die Träger 5 sind jeweils angepasst auf die Länge der beiden Armelemente 26 und 27 angefertigt, so dass Näherungssensoren 7 an beiden Armelemente 26 und 27 über deren gesamte Länge verteilt sind. In Fig. 6 sind Umrisse der Näherungssensoren 7 mit gestrichelten, Linien angedeutet.

Der Roboter 23 kann seine Armelemente 26 und 27 in verschiedene Richtungen bewegen. Das untere Armelement 26 ist mittels einer Gelenkeinheit 25 gegenüber einem feststehenden Sockel 24 um eine vertikale erste Achse 31 und eine in der hier gezeigten Konfiguration zur Zeichnungsebene senkrechte zweite Achse 32 drehbar gelagert. Das obere Armelement 27 ist gegenüber dem unteren Armelement 26 mittels einer weiteren Gelenkeinheit 25 um eine zur zweiten Achse parallele dritte Achse 33 und um eine in seiner Längsrichtung verlaufende vierte Achse 34 drehbar gelagert. Ferner ist ein Instrument 28 mittels einer weiteren Gelenkeinheit 25 gegenüber dem oberen Armelement 27 drehbar gelagert.

Gerät ein Objekt 30 in den Erfassungsbereich zumindest eines der an den Armelementen 26 und 27 befindlichen Näherungssensoren 7, erzeugt dieser Näherungssensor 7 ein Signal und leitet dieses an eine Steuereinheit 29, die im Sockel 24 untergebracht sein kann. Die Steuereinheit 29 kann daraufhin eine geeignete Sicherheitsmaßnahme zum Schutz vor einer Kollision des Roboters 23 mit dem Objekt 30 einleiten und beispielsweise eine Bewegung des Roboters 23 stoppen.

Näherungssensoren der beiden Armelemente 26, 27, insbesondere solche in der Nähe der Gelenkeinheit 25 können einander auch gegenseitig erfassen, wenn sie einander durch Schwenken um die dritte Achse 33 nahekommen. Wenigstens am Armelement 26 sind die Steckrichtungen R, L parallel zur dritten Achse 33 ausgerichtet, so dass stets die Näherungssensoren eines der beiden am Armelement 26 montierten Träger 5 vom anderen Armelement 27 abgewandt sind und durch dieses nicht gestört werden.

Um die Reichweite des Erfassungsbereichs der Näherungssensoranordnung 1 zu erhöhen, kann die Steuereinheit 29 die an einem gleichen Träger 5 befindlichen Näherungssensoren 7 allesamt oder in Gruppen von jeweils einander benachbarten Näherungssensoren 7 parallel schalten, um einen zusammengesetzten Sensor mit größerer Elektrodenfläche zu schaffen. Wurde ein Objekt 30 von einem solchen zusammengesetzten Sensor erfasst, kann die Parallelschaltung vollständig oder in Teilen wieder aufgehoben werden.

Zwar wird dadurch die Reichweite wieder reduziert, jedoch kann die Stelle des Armelements 26 oder 27, der sich das Objekt 30 annähert, präziser lokalisiert werden, da die nicht parallel geschalteten Näherungssensoren Objekte voneinander losgelöst erkennen können.

### Bezugszeichen

- 1: Näherungssensoranordnung
- 2: Unterlage
- 3: Oberfläche
- 4: Platine
- 5: Träger
- 6: Längsrichtung
- 7: Näherungssensor
- 8: Messelektrode
- 9: Schildelektrode
- 10: Vorsprung
- 11: Bohrung
- 12: Vorsprung
- 13: Schraube
- 14: Rand
- 15: Rand
- 16: Schraube
- 17: Gehäuse
- 18: Hohlraum
- 19: Hohlraum
- 20: Federpaar
- 21: Feder
- 22: Feder
- 23: Roboter
- 24: Sockel
- 25: Gelenkeinheit
- 26: Armelement
- 27: Armelement
- 28: Instrument
- 29: Steuereinheit
- 30: Objekt
- 31: Achse
- 32: Achse
- 33: Achse
- 34: Achse
- 35: Kontaktfläche
- 36: Kontaktfläche
- 37: Kontaktfläche
- 38: Kontaktfläche
- 39: Durchbruch
- 40: Schenkel
- 41: Schenkel
- 42: Welle

## Patentansprüche

1. Näherungssensoranordnung (1) mit einer Unterlage (2), und wenigstens einem Träger (5), der wenigstens einen Näherungssensor (7) mit einer Messelektrode (8) und einer sich zwischen der Messelektrode (8) und einer Oberfläche (3) erstreckenden Schildelektrode (9) trägt, **dadurch gekennzeichnet, dass** eine Kontaktflächen (35, 37) tragende Platine (4) auf der Oberfläche (3) der Unterlage (2) montiert ist, dass der Träger (5) zu den Kontaktflächen (35, 37) der Platine (4) komplementäre Kontaktflächen (36, 38) aufweist, dass zum elektrischen Inkontaktbringen der Kontaktflächen (35, 36, 37, 38) der Platine (4) und des Trägers (5) die Unterlage (2) und der Träger (5) in einer zu der Oberfläche (3) parallelen Steckrichtung (R, L) steckverbunden sind, und dass die Mess- und Schildelektroden (8, 9) mit den Kontaktflächen (36, 38) des Trägers (5) elektrisch verbunden sind.

2. Näherungssensoranordnung (1) nach Anspruch 1, **dadurch gekennzeichnet, dass** die Kontaktflächen (35, 36, 37, 38) der Platine (4) und des Trägers (5) in der Steckrichtung (L, R) ausgedehnt sind.

3. Näherungssensoranordnung (1) nach Anspruch 1 oder 2, **dadurch gekennzeichnet, dass** der Träger (5) die Unterlage (2) reib- und/oder formschlüssig umgreift.

4. Näherungssensoranordnung (1) nach einem der vorhergehenden Ansprüche, **dadurch gekennzeichnet, dass** die Kontaktflächen (35, 36, 37, 38) Teile von zueinander komplementären elektrischen Steckverbindern des Trägers (5) und der Platine (4) sind, die die Steckverbindung zwischen Unterlage (2) und Träger (5) vermitteln.

5. Näherungssensoranordnung (1) nach Anspruch 3 oder 4, **dadurch gekennzeichnet, dass** der Träger (5) eine starre Grundplatte aufweist und die Messelektrode (8) und die Schildelektrode (9) an entgegengesetzten Oberflächen der Grundplatte angeordnet sind.

6. Näherungssensoranordnung (1) nach Anspruch 5, soweit auf Anspruch 4 rückbezogen, **dadurch gekennzeichnet, dass** einer der komplementären Steckverbinder einen Rand (14) der Grundplatte oder der Platine (4) umfasst und die Kontaktflächen (35, 36, 37, 38) auf dem Rand (14) angeordnete Kontaktfelder sind.

7. Näherungssensoranordnung (1) nach Anspruch 6, **dadurch gekennzeichnet, dass** jeweils eines der Kontaktfelder einteilig mit der Messelektrode (8) und ein anderes einteilig mit der Schildelektrode (9) ausgebildet ist.

8. Näherungssensoranordnung (1) nach Anspruch 6 oder 7, **dadurch gekennzeichnet, dass** die Grundplatte über die die Schildelektrode (9) tragende Oberfläche überstehende Vorsprünge (12) aufweist.

9. Näherungssensoranordnung (1) nach Anspruch 8, **dadurch gekennzeichnet, dass** wenigstens einer der Vorsprünge (12) eine entlang einer Kante der Schildelektrode (9) verlaufende Rippe ist.

10. Näherungssensoranordnung (1) nach Anspruch 8 oder 9, **dadurch gekennzeichnet, dass** eine die Grundplatte kreuzende Bohrung (11) durch wenigstens einen der Vorsprünge (12) verläuft.

11. Näherungssensoranordnung (1) nach einem der vorhergehenden Ansprüche, **dadurch gekennzeichnet, dass** der Träger (5) an der Platine (4) durch wenigstens eine quer zur Steckrichtung (L, R) orientierte Schraube (13) gesichert ist.

12. Näherungssensoranordnung (1) nach einem der vorhergehenden Ansprüche, **dadurch gekennzeichnet, dass** der Träger (5) als sich in einer Längsrichtung (6) erstreckende Rinne geformt ist.

13. Näherungssensoranordnung (1) nach Anspruch 12, **dadurch gekennzeichnet, dass** zwei Träger (5) sich zu einer die Unterlage (2) rohrförmig umschließenden Hülle ergänzen.

14. Näherungssensoranordnung (1) nach einem der Ansprüche 12 bis 13, **dadurch gekennzeichnet, dass** die Messelektrode (8) und Schildelektrode (9) des Näherungssensors (7) sich in einer Querrichtung von einem Rand (14) des Trägers (5) zu einem gegenüberliegenden Rand (15) erstrecken.

15. Näherungssensoranordnung (1) nach einem der vorhergehenden Ansprüche, **dadurch gekennzeichnet, dass** mehrere Näherungssensoren (7) am Träger (5) in einer Längsrichtung (6) verteilt sind.

16. Näherungssensoranordnung (1) nach Anspruch 15, **dadurch gekennzeichnet, dass** Kontaktflächen (35, 37) zum Kontaktieren der mehreren Näherungssensoren (7) entlang der Platine verteilt sind.

17. Näherungssensoranordnung (1) nach Anspruch 15, **dadurch gekennzeichnet, dass** die Platine (4) zwei Gruppen von Kontaktflächen (35, 37) aufweist und dass zwei Träger (5) aus einander entgegengesetzten Steckrichtungen (L, R) mit der Unterlage (2) steckverbunden sind.

18. Näherungssensoranordnung (1) nach einem der Ansprüche 12 bis 17, **dadurch gekennzeichnet, dass** die Messelektroden (8) der Näherungssensoren (7) in der Längsrichtung (6) schmaler als die Schildelektroden (9) sind.

## Claims

1. A proximity sensor assembly (1) having a base (2) and at least one support (5) which carries at least one proximity sensor (7) having a measuring electrode (8) and a shield electrode (9) extending between the measuring electrode (8) and a surface (3), **characterized in that** a printed circuit board (4) carrying contact surfaces (35, 37) is mounted on said surface (3) of the base (2), **in that** the support (5) has contact surfaces (36, 38) complementary to the contact surfaces (35, 37) of the printed circuit board (4), and that, in order to bring into electrical contact the contact surfaces (35, 36, 37, 38) of the printed circuit board (4) and of the support (5), the base (2) and the support (5) are plug-in connected in a plug-in direction (R, L) parallel to the surface (3), and **in that** the measuring and shield electrodes (8, 9) are electrically connected to the contact surfaces (36, 38) of the support (5).

2. The proximity sensor assembly (1) of claim 1, **characterised in that** the contact surfaces (35, 36, 37, 38) of the circuit board (4) and of the support (5) are elongate in the plug-in direction (L, R).

3. The proximity sensor assembly (1) of claim 1 or 2, **characterised in that** the support (5) engages around the base (2) in a frictional and/or positive-locking manner.

4. The proximity sensor assembly (1) of any of the preceding claims, **characterized in that** the contact surfaces (35, 36, 37, 38) are parts of mutually complementary electrical connectors of the support (5) and of the circuit board (4), which provide the plug-in connection between the base (2) and the support (5).

5. The proximity sensor assembly (1) of claim 3 or 4, **characterised in that** the support (5) has a rigid base plate, the measuring electrode (8) and the shield electrode (9) being disposed on opposite surfaces of the base plate.

6. The proximity sensor assembly (1) of claim 5, insofar as referred back to claim 4, **characterized in that** one of the complementary connectors comprises an edge (14) of the base plate or of the board (4) and that the contact surfaces (35, 36, 37, 38) are contact pads arranged on said edge (14).

7. The proximity sensor assembly (1) of claim 6, **characterised in that** one of the contact pads is formed integrally with the measuring electrode (8) and another is formed integrally with the shield electrode (9).

8. The proximity sensor assembly (1) of claim 6 or 7, **characterised in that** the base plate has projections (12) projecting beyond the surface carrying the shield electrode (9).

9. The proximity sensor assembly (1) of claim 8, **characterised in that** at least one of the projections (12) is a rib extending along an edge of the shield electrode (9).

10. The proximity sensor assembly (1) of claim 8 or 9, **characterised in that** a bore (11) crossing the base plate extends through at least one of the projections (12).

11. The proximity sensor assembly (1) of one of the preceding claims, **characterized in that** the support (5) is secured to the circuit board (4) by at least one screw (13) oriented transversely to the plug-in direction (L, R).

12. The proximity sensor assembly (1) of any one of the preceding claims, **characterized in that** the support (5) is shaped as a trough extending in a longitudinal direction (6).

13. The proximity sensor assembly (1) of claim 12, **characterised in that** two supports (5) complement each other to form an envelope which surrounds the base (2) in the form of a tube.

14. The proximity sensor assembly (1) of any of claims 12 to 13, **characterized in that** the measuring electrodes (8) and shield electrodes (9) of the proximity sensor (7) extend in a transverse direction from one edge (14) of the support (5) to an opposite edge (15).

15. The proximity sensor assembly (1) of any of the preceding claims, **characterized in that** a plurality of proximity sensors (7) are distributed on the support (5) in a longitudinal direction (6).

16. The proximity sensor assembly (1) of claim 15, **characterised in that** contact surfaces (35, 37) for contacting the plurality of proximity sensors (7) are distributed along the circuit board.

17. The proximity sensor assembly (1) of claim 15, **characterized in that** the circuit board (4) has two groups of contact surfaces (35, 37) and **in that** two supports (5) are plugged into the base (2) from opposite plug-in directions (L, R).

18. The proximity sensor assembly (1) of any of claims 12 to 17, **characterized in that** the measuring electrodes (8) of the proximity sensors (7) are narrower in the longitudinal direction (6) than the shield electrodes (9).

## Revendications

1. Ensemble capteur de proximité (1) comportant un socle (2) et au moins un support (5) qui porte au moins un capteur (7) de proximité ayant une électrode (8) de mesure et une électrode (9) de blindage s'étendant entre l'électrode (8) de mesure et une surface (3), **caractérisé en ce qu'**il est monté sur ladite surface (3) du socle (2) une carte de circuit imprimé (4) portant des plages de contact (35, 37), **en ce que** le support (5) a des plages de contact (36, 38) complémentaires des plages de contact (35, 37) de la carte de circuit imprimé (4) et **en ce que** pour mettre en contact électrique les plages de contact (35, 36, 37, 38) de la platine (4) et du support (5), le socle (2) et le support (5) sont enfichés l'un dans l'autre dans une direction d'enfichage (R, L) parallèle à la surface (3), et **en ce que** les électrodes de mesure et de blindage (8, 9) sont reliées électriquement aux plages de contact (36, 38) du support (5).

2. Ensemble capteur de proximité (1) selon la revendication 1, **caractérisé en ce que** les plages de contact (35, 36, 37, 38) de la carte de circuit imprimé (4) et du support (5) sont prolongées dans la direction d'enfichage (L, R).

3. Ensemble capteur de proximité (1) selon la revendication 1 ou 2, **caractérisé en ce que** le support (5) s'engage autour de la base (2) par friction et/ou par complémentarité de forme.

4. Ensemble capteur de proximité (1) selon l'une des revendications précédentes, **caractérisé en ce que** les plages de contact (35, 36, 37, 38) font partie de connecteurs électriques complémentaires du support (5) et de la carte de circuit imprimé (4), qui assurent la liaison par enfichage entre la base (2) et le support (5).

5. Ensemble capteur de proximité (1) selon la revendication 3 ou 4, **caractérisé en ce que** le support (5) comprend une plaque de base rigide et l'électrode de mesure (8) et l'électrode de blindage (9) sont disposées sur des surfaces opposées de la plaque de base.

6. Ensemble capteur de proximité (1) selon la revendication 5, dans la mesure où celle-ci dépend de la revendication 4, **caractérisé en ce que** l'un des connecteurs complémentaires comprend un bord (14) de la plaque de base ou de la carte de circuit imprimée (4) et les plages de contact (35, 36, 37, 38) sont des plaquettes de contact disposées sur le bord (14).

7. Ensemble capteur de proximité (1) selon la revendication 6, **caractérisé en ce qu'**une des plaquettes de contact est formée d'un seul tenant avec l'électrode de mesure (8) et une autre est formée d'un seul tenant avec l'électrode de blindage (9).

8. Ensemble capteur de proximité (1) selon la revendication 6 ou 7, **caractérisé en ce que** la plaque de base présente des saillies (12) dépassant de la surface portant l'électrode de blindage (9).

9. Ensemble capteur de proximité (1) selon la revendication 8, **caractérisé en ce qu'**au moins une des saillies (12) est une nervure s'étendant le long d'un bord de l'électrode de blindage (9).

10. Ensemble capteur de proximité (1) selon la revendication 8 ou 9, **caractérisé en ce qu'**un alésage (11) traversant la plaque de base s'étend à travers au moins une des saillies (12).

11. Ensemble capteur de proximité (1) selon l'une des revendications précédentes, **caractérisé en ce que** le support (5) est fixé à la carte de circuit imprimé (4) par au moins une vis (13) orientée transversalement par rapport à la direction d'enfichage (L, R).

12. Ensemble capteur de proximité (1) selon l'une des revendications précédentes, **caractérisé en ce que** le support (5) a la forme d'une gouttière s'étendant dans une direction longitudinale (6).

13. Ensemble capteur de proximité (1) selon la revendication. 12, **caractérisé en ce que** deux supports (5) se complémentent pour former une enveloppe qui entoure la base (2) de manière tubulaire.

14. Ensemble capteur de proximité (1) selon l'une quelconque des revendications 12 à 13, **caractérisé en ce que** l'électrode de mesure (8) et l'électrode de blindage (9) du capteur de proximité (7) s'étendent dans une direction transversale d'un bord (14) du support (5) jusqu'à un bord opposé (15).

15. Ensemble capteur de proximité (1) selon l'une des revendications précédentes, **caractérisé en ce qu'**une pluralité de capteurs de proximité (7) sont répartis sur le support (5) dans une direction longitudinale (6).

16. Ensemble capteur de proximité (1) selon la revendication 15, **caractérisé en ce que** des plages de contact (35, 37) pour contacter la pluralité de capteurs de proximité (7) sont réparties le long de la carte.

17. Ensemble capteur de proximité (1) selon la revendication 15, **caractérisé en ce que** la carte de circuit imprimé (4) présente deux groupes de plages de contact (35, 37) et **en ce que** deux supports (5) sont enfichés dans le socle (2) à partir de directions d'enfichage (L, R) mutuellement opposées.

18. Ensemble capteur de proximité (1) selon l'une des revendications 12 à 17, **caractérisé en ce que** les électrodes de mesure (8) des capteurs de proximité (7) sont plus étroites dans la direction longitudinale (6) que les électrodes de blindage (9).
